# EUROPEAN PATENT APPLICATION

(11) **EP 2 819 200 A2**
(43) Date of publication of application: **31.12.2014**
(21) Application number: 14151714.4
(22) Date of filing: 20.01.2014
(51) Int. Cl.: H01L 51/52, F21S 8/04, F21Y 105/00

(54) **Light emitting panel and lighting apparatus**

(30) Priority: 28.06.2013 JP 2013136790
(71) Applicant: Toshiba Lighting & Technology Corporation, Yokosuka-shi, Kanagawa 237-8510 (JP); Kabushiki Kaisha Toshiba, Minato-ku, Tokyo 105-8001 (JP)
(72) Inventor: Kaneko, Takashi, Kanagawa, 237-8510 (JP); Hayashi, Junya, Kanagawa, 237-8510 (JP)
(74) Representative: Willquist, Sofia Ellinor

(57) **Abstract**

According to one embodiment, a light emitting panel (11) includes: an organic layer (30) including a light emitting layer (32); a transparent first electrode (21) provided on one surface of the organic layer; and a second electrode (22) provided on the other surface of the organic layer. The second electrode includes an opaque first metal film section (22a) and a second metal film section (22b) having a film thickness thinner than a film thickness of the first metal film section and light transparency higher than light transparency of the first metal film section.

## Description

### FIELD

Embodiments described herein relate generally to a light emitting panel and a lighting apparatus.

### BACKGROUND

As a light source of a lighting apparatus, an Organic Light-Emitting Diode (OLED) using organic electroluminescence is proposed. In the typical OLED, a transparent electrode such as Indium Tin Oxide (ITO) is used as an electrode on a side of a light take-out surface and an opaque metal electrode such as aluminum or silver is used as an electrode on a side of a back surface. Light that is radiated from a light emitting layer and directed to the side of the back surface is reflected in the metal electrode and then is taken out from the side of the transparent electrode. In this structure, the light does not come around the side of the back surface and a space thereof is seen as dark.

### BRIEF DESCRIPTION OF THE DRAWINGS

FIGS. 1A and 1B are schematic views of a light emitting panel of a first embodiment.
FIGS. 2A and 2B are schematic views of a lighting apparatus using the light emitting panel of the first embodiment.
FIGS. 3A and 3B are schematic views of another specific example of the light emitting panel of the first embodiment.
FIGS. 4A and 4B are schematic views of a lighting apparatus of a second embodiment.
FIGS. 5A and 5B are schematic views of a lighting apparatus of a third embodiment.
FIGS. 6A and 6B are schematic views of a lighting apparatus of a fourth embodiment.
FIG. 7 is a schematic view of a light emitting panel used for the lighting apparatus of the fourth embodiment.
FIG. 8 is a graph illustrating a relationship between a film thickness of an Ag film and a transmission.

### DETAILED DESCRIPTION

According to an embodiment, a light emitting panel includes an organic layer having a light emitting layer; a transparent first electrode provided on one surface of the organic layer; and a second electrode provided on the other surface of the organic layer. The second electrode has an opaque first metal film section and a second metal film section having a film thickness thinner than a film thickness of the first metal film section and light transparency higher than light transparency of the first metal film section.

Hereinafter, an embodiment will be described with reference to the drawings. Moreover, the same reference numerals are given to the same elements in each of the drawings.

### First Embodiment

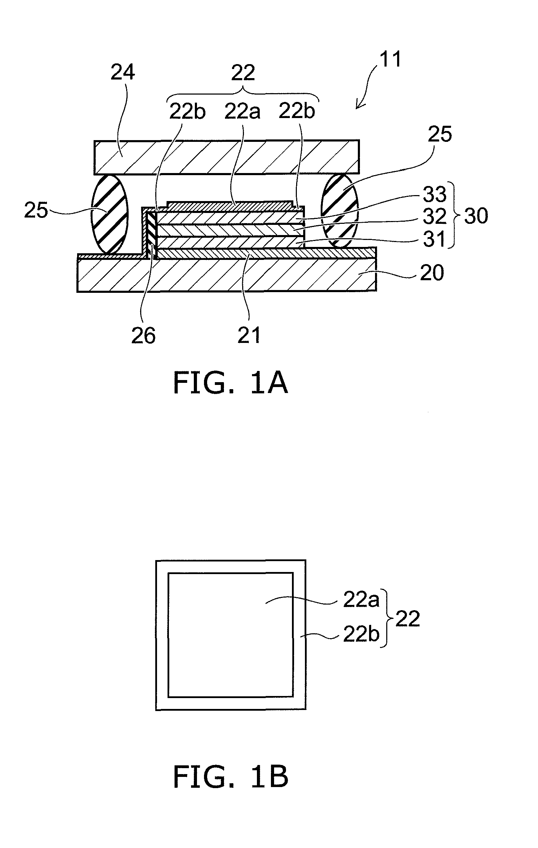

FIG. 1A is a schematic cross-sectional view of a light emitting panel 11 of a first embodiment.

The light emitting panel 11 has an organic layer 30, a first electrode 21 that is provided on one surface of the organic layer 30, and a second electrode 22 that is provided on the other surface of the organic layer 30. The organic layer 30, the first electrode 21 and the second electrode 22 are supported on a substrate 20. The organic layer 30 includes a light emitting layer 32.

The substrate 20 is a transparent substrate and is, for example, a glass substrate. Otherwise, the substrate 20 may be a transparent resin substrate.

In the specification, the term "transparent" refers to having transparency to the light emitted from the light emitting layer 32 and is not limited to light transmission of 100%. Particularly, it means that the transmission is 20% or more and is preferably 30% or more at a wavelength of 550 nm. The light emitting layer 32 emits visible light. Further, the term "transparent" also refers to having transparency to a transmitting signal of a remote controller or to detection target light of a human sensor or the like. For example, the term "transparent" also refers to having transparency to infrared radiation.

The term "opaque" refers to having a light shielding property or a reflective property to the light emitted from the light emitting layer 32. The term "opaque" is not limited to the transmission of 0% of the light emitted from the light emitting layer 32 and also refers to a case where the transmission is relatively lower than that of a transparent region. Particularly, it means that the transmission is 20% or less and is preferably 15% or less at the wavelength of 550 nm.

As illustrated in FIG. 1A, the first electrode 21 is provided on the substrate 20. The first electrode 21 is a transparent electrode and, for example, is made of Indium Tin Oxide (ITO), Indium Zinc Oxide (IZO), a conductive polymer or the like.

The organic layer 30 is provided on the first electrode 21. The organic layer 30 includes the light emitting layer 32, a hole transport layer 31 and an electron transport layer 33. The hole transport layer 31 is provided on the first electrode 21, the light emitting layer 32 is provided on the hole transport layer 31, and the electron transport layer 33 is provided on the light emitting layer 32.

The second electrode 22 is provided on the electron transport layer 33. Further, the second electrode 22 is also provided on a part of the surface of the substrate 20. The second electrode 22 is continuously provided from the surface of the substrate 20 to an upper surface of the organic layer 30 so as to coat a step between the surface of the substrate 20 and the upper surface of the organic layer 30.

An insulation film 26 is provided between the second electrode 22 and a side surface of the organic layer 30, and between the second electrode 22 and an end portion of the first electrode 21.

A transparent sealing member 24 is superimposed on the substrate 20 through a sealing body 25. A laminated body including the organic layer 30, the first electrode 21 and the second electrode 22 is sealed between the substrate 20 and the transparent sealing member 24.

The sealing member 24 is a glass substrate or a transparent resin. The sealing body 25 is, for example, made of resin and is continuously provided around a region between the substrate 20 and the sealing member 24.

Next, the second electrode 22 will be described in detail. FIG. 1B is a schematic top plan view of the second electrode 22 on the organic layer 30.

The second electrode 22 is a metal film and has a first metal film section 22a and a second metal film section 22b. The first metal film section 22a and the second metal film section 22b are integrally provided with the same metal film and have relatively different film thicknesses.

The film thickness of the second metal film section 22b is thinner than that of the first metal film section 22a. The first metal film section 22a has a thickness through which the light emitted from the light emitting layer 32 is hardly transmitted and a region in which the first metal film section 22a is provided is an opaque region.

Since the second metal film section 22b is thinner than the first metal film section 22a, the light transmission thereof is higher than that of the first metal film section 22a and the second metal film section 22b transmits the light emitted from the light emitting layer 32. A region in which the second metal film section 22b is provided is a transparent region.

The second electrode 22 is, for example, a silver (Ag) film or an aluminum (Al) film.

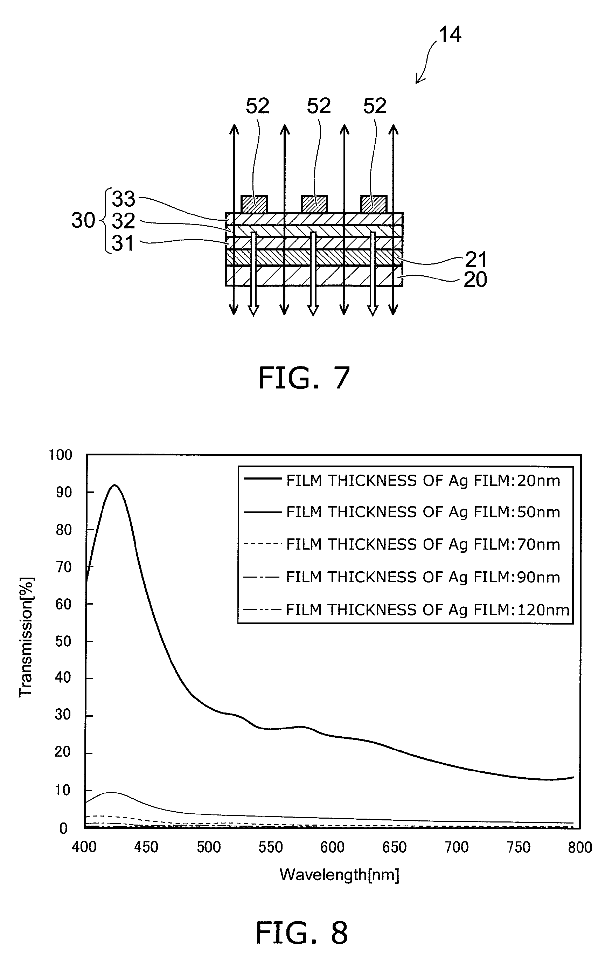

FIG. 8 is a graph illustrating a relationship between a film thickness and the light transmission of the Ag film.
A horizontal axis refers to the wavelength (nm) and a vertical axis refers to the transmission (%).

For example, the Ag film can be a transparent film to the visible light by the film thickness of the Ag film being 20 nm or less. From experience, if the film thickness of the Ag film is 30 nm or less, the transmission can be 20% or more at the wavelength of 550 nm or less. That is, the film thickness of the second metal film section 22b is preferably 30 nm or less. Moreover, a function as an electrode for supplying a current to the light emitting layer while diffusing in a plane direction is sufficient as long as the film thickness is 10 nm. On the other hand, the film thickness of the first metal film section 22a is preferably 30 nm or more. However, since the function as the electrode does not vary if the film thickness is 200 nm or more, the film thickness of the first metal film section 22a is preferably 200 nm or less.

Further, the first metal film section 22a which is relatively thick has a reflective property to the light emitted from the light emitting layer 32 higher than that of the second metal film section 22b. Therefore, the light that is emitted from the light emitting layer 32 and is directed to the side of the second electrode 22 is reflected in the first metal film section 22a of the second electrode 22 and is taken out on the side of the transparent substrate 20 through the first electrode 21 that is the transparent electrode.

As illustrated in FIG. 1B, the second metal film section 22b of the second electrode 22 is provided on the side of an outer periphery of the organic layer 30 and the first metal film section 22a is provided inside the second metal film section 22b. The first metal film section 22a is provided in a region including a center portion of the organic layer 30 in the plane direction and the second metal film section 22b continuously encloses the periphery of the first metal film section 22a.

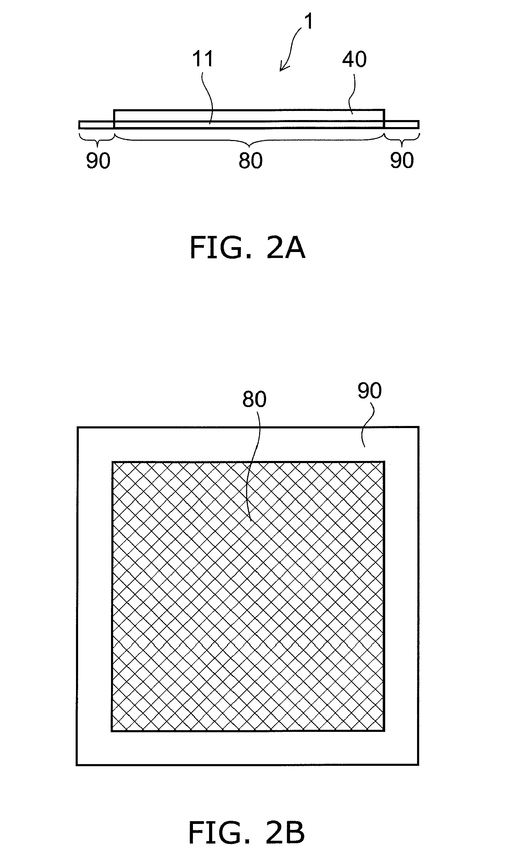

Next, FIG. 2A is a schematic view of a lighting apparatus 1 using the light emitting panel 11 illustrated in FIG. 1A.

An apparatus body 40 is provided on the side of a back surface (on the side of the sealing member 24) in the light emitting panel 11. The apparatus body 40 holds the light emitting panel 11.

For example, a ceiling surface is positioned on the upper side in FIG. 2A. The lighting apparatus 1 is attached to the ceiling surface through the apparatus body 40 in a state where a light take-out surface (a surface on the side of the substrate 20) of the light emitting panel 11 is directed downward on the opposite side to the ceiling surface.

FIG. 2B is a schematic plan view of the lighting apparatus 1.

An opaque region 80 in which the first metal film section 22a of the second electrode 22 is provided is represented by cross-hatching in FIG. 2B. A transparent region 90 in which the second metal film section 22b of the second electrode 22 is provided is formed in a periphery of the opaque region 80. The transparent region 90 continuously encloses the periphery of the opaque region 80.

The apparatus body 40 is provided by being superimposed on the opaque region 80. An external size of the apparatus body 40 is sized to fit within the opaque region 80 and the apparatus body 40 is not superimposed on the transparent region 90. Otherwise, a part of the apparatus body 40 may protrude on the side of the transparent region 90 from the opaque region 80. In any event, at least a part of the transparent region 90 is not covered by the apparatus body 40 and it is possible to take out the light from the transparent region 90 to the side of the back surface (the side of the ceiling).

The first electrode 21 functions as an anode and the second electrode 22 functions as a cathode in an OLED. If a relatively high potential is applied to the first electrode 21 and a relatively low potential is applied to the second electrode 22, holes are injected from the first electrode 21 into the light emitting layer 32 through the hole transport layer 31 and electrons are injected from the second electrode 22 into the light emitting layer 32 through the electron transport layer 33. Then, the holes and the electrons are recombined in the light emitting layer 32 and the light emitting layer 32 emits the light with energy generated at this time.

The light emitted from the light emitting layer 32 is directed to the side of the first electrode 21 and to the side of the second electrode 22. The light directed to the side of the first electrode 21 is transmitted through the first electrode 21 that is the transparent electrode and the transparent substrate 20, and is radiated to the side of a main light take-out surface on the opposite side to the ceiling surface.

The light directed from the light emitting layer 32 to the side of the second electrode 22 is reflected in the first metal film section 22a that is the opaque region and is taken out to the side of the substrate 20. Thus, it is possible to increase a light amount radiated to the side of the main light take-out surface.

One-side emission is performed in the opaque region in which the first metal film section 22a is provided. By contrast, both-side emission is performed in the transparent region in which the second metal film section 22b is provided.

That is, a part of the light directed from the light emitting layer 32 to the side of the second electrode 22 is taken out to the side of the ceiling surface by being transmitted through the second metal film section 22b. At this time, since the apparatus body 40 does not cover the transparent region 90 in which the second metal film section 22b is provided, the light directed to the side of the ceiling surface is not blocked by the apparatus body 40.

That is, according to the embodiment, it is possible to take out the light to the side of the back surface and to illuminate an installation surface such as the ceiling surface without providing a separate light source on the side of the back surface of the lighting apparatus 1. Therefore, it is possible to increase a feeling of brightness of a space in which a user is located by an indirect lighting effect and it is possible to create a sense of an extent or a depth of the space.

Moreover, it is possible for the light to be illuminated on the side of the ceiling surface by a both-side emission structure in which an entire region of the second electrode 22 on the side of the back surface is the transparent electrode. However, for the both-side emission, half of the light emission energy is lost by escaping to the opposite side to the main light take-out surface.

By contrast, according to the embodiment, the transparent region 90 (the second metal film section 22b) is not in the entire region of the organic layer 30 on the side of the back surface but is a part thereof. The first metal film section 22a that functions as a reflective metal is also provided on the side of the back surface. Therefore, according to the embodiment, it is also possible to illuminate the side of the installation surface such as the ceiling surface while suppressing reduction of the light amount radiating to the side of the main light take-out surface. Moreover, in order to increase a yield property while obtaining a sufficient light amount on the side of the main light take-out surface, the area of the opaque region is preferably 0.05 times to 4 times of the area of the transparent region. That the area of the opaque region be one time, that is, equal to the area of the transparent region is most suitable.

In addition, in order to make a part of the second electrode transparent, a part of the second electrode may be made by a transparent electrode such as ITO or IZO. However, ITO or IZO is typically formed by a sputtering method and there is a concern that the upper surface of the organic layer 30 may be damaged when sputtering is performed.

By contrast, according to the embodiment, the transparent section and the opaque section are mixed in the second electrode 22 by the difference of the film thickness of the metal film. For example, the metal film such as Ag or Al is formed on the upper surface of the organic layer 30 by a vapor depositing method. Thus, when forming the second electrode 22, the organic layer 30 is not damaged.

For example, first, a thin metal film is formed on the entirety of the upper surface of the organic layer 30. Thereafter, the metal film is further deposited only on a portion to have thick film thickness using a mask. Therefore, it is possible to form the metal film on the upper surface of the organic layer 30 by generating the difference in the film thickness.

Moreover, when forming the thin film and when forming additional film to thicken the thickness, it is possible to form the first metal film section 22a and the second metal film section 22b of different materials by changing a material of an vapor depositing source.

Further, the second metal film section 22b (the transparent region 90) has transparency to infrared radiation. Thus, it is possible to remotely control the lighting apparatus 1 by providing a receiving section of a transmitting signal of the remote controller that operates the lighting apparatus 1 on the back side of the transparent region 90 in the light emitting panel 11. Otherwise, it is also possible to provide a receiving section of the human sensor, a brightness sensor or the like on the back side of the transparent region 90.

It is possible to reduce a planar size of the entirety of the lighting apparatus 1 by providing the receiving section described above in a position superimposed on the light emitting panel 11 without providing the receiving section on the outside of an end portion of the light emitting panel 11.

A planar layout of the first metal film section 22a and the second metal film section 22b in the second electrode 22 is not limited to the layout illustrated in FIG. 1B.

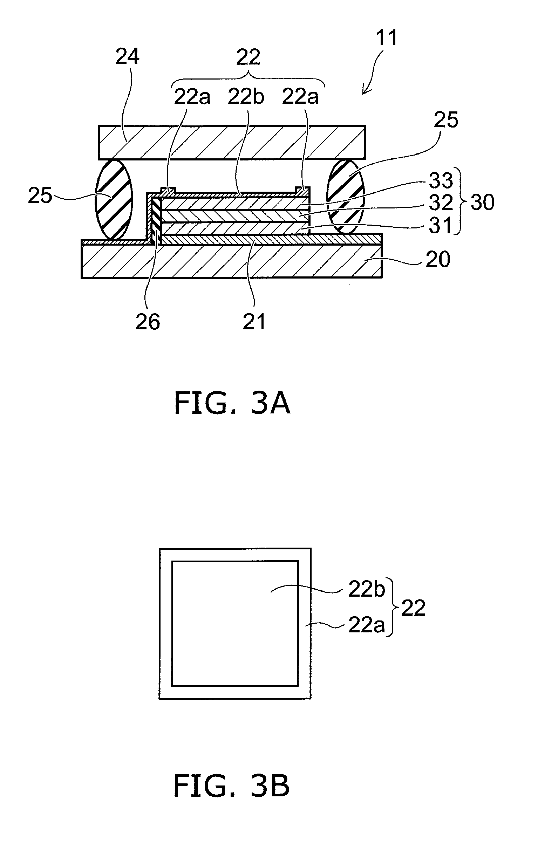

FIG. 3A is a schematic cross-sectional view of another specific example of the light emitting panel 11.
FIG. 3B is a schematic top plan view of the second electrode 22 on the organic layer 30 illustrated in FIG. 3A.

The first metal film section 22a of the second electrode 22 which is relatively thick is provided on the side of the outer periphery of the organic layer 30 and the second metal film section 22b which is relatively thin is provided inside the first metal film section 22a. The second metal film section 22b is provided in a region including the center portion of the organic layer 30 in the plane direction and the first metal film section 22a continuously surrounds the periphery of the second metal film section 22b.

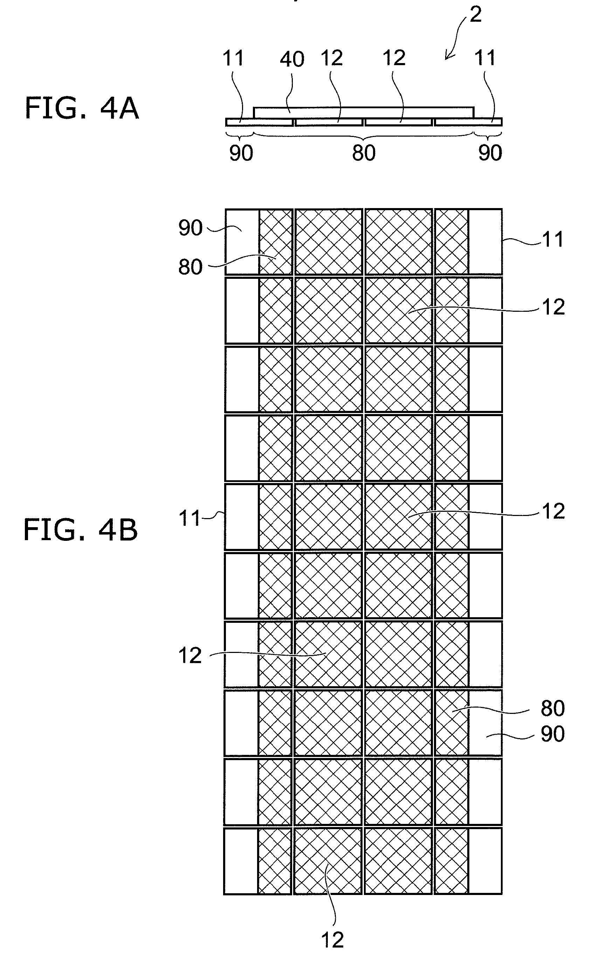

Otherwise, for the light emitting panel 11 illustrated in FIG. 4B described below, the first metal film section 22a (the opaque region 80) and the second metal film section 22b (the transparent region 90) may be laid out so as to divide in half a square-shaped plane region of the organic layer 30.

In the transparent region 90 in which the second metal film section 22b is provided, the light directed from the light emitting layer 32 to the side of the back surface is transmitted through the second metal film section 22b and is not reflected on the side of the substrate 20 (on the side of the main light take-out surface). Then, it is possible to compensate for the light amount radiating to the side of the main light take-out surface (the side of the substrate 20) in the transparent region (the both-side emission region) 90 by making a voltage applied between the second metal film section 22b and the first electrode 21 greater than that applied between the first metal film section 22a and the first electrode 21.

It is possible to apply different voltages to the transparent region 90 and the opaque region 80 by patterning the second electrode 22 by separating the first metal film section 22a and the second metal film section 22b.

Further, the film thickness in the second electrode 22 is not limited to be changed in a single stage and may be changed in multiple stages. In addition, the film thickness of a boundary region between the first metal film section 22a and the second metal film section 22b may be continuously changed or may be changed in multiple stages. In this case, it is possible to reduce difference in the brightness between the opaque region 80 and the transparent region 90.

### Second Embodiment

FIG. 4A is a schematic view of a lighting apparatus 2 of a second embodiment.
FIG. 4B is a schematic plan view of the lighting apparatus 2 of the second embodiment.

The lighting apparatus 2 of the second embodiment has a plurality of first light emitting panels 11 and a plurality of second light emitting panels 12 which are arranged in the tiled arrangement. The plurality of first light emitting panels 11 and the plurality of second light emitting panels 12 are held on the apparatus body 40.

For example, the ceiling surface is positioned on the upper side in FIG. 4A. The lighting apparatus 2 is attached to the ceiling surface through the apparatus body 40 in a state where the first light emitting panel 11 and the second light emitting panel 12 are directed downward on the opposite side to the ceiling surface.

The opaque region is represented by cross-hatching in FIG. 4B.

The first light emitting panel 11 has the same structure as the light emitting panel 11 of the first embodiment. However, in the first light emitting panel 11 of the second embodiment, the first metal film section 22a (the opaque region 80) and the second metal film section 22b (the transparent region 90) are laid out so as to divide in half the square-shaped plane region of the organic layer 30.

The second light emitting panel 12 is also the light emitting panel having the OLED structure using organic electroluminescence. That is, the second light emitting panel 12 has a structure in which the organic layer including the light emitting layer is sandwiched between the first electrode and the second electrode.

In the second light emitting panel 12, similar to the first light emitting panel 11, the first electrode is provided on the side of the transparent substrate and is transparent. The second electrode is the metal film. The second electrode thereof has a sufficient thickness throughout the entire region on the upper surface of the organic layer and is opaque. That is, the second light emitting panel 12 is the opaque light emitting panel of the one-side emission type where the side of the back surface on which the second electrode is provided in the organic layer is opaque.

The side of the first electrode (the side of the substrate) with the first light emitting panel 11 and the second light emitting panel 12 is the main light take-out surface, and the apparatus body 40 is provided on the side of the back surface (the side of the second electrode) on the other side thereof.

As illustrated in FIG. 4B, the light emitting surface on which the plurality of first light emitting panels 11 and the plurality of second light emitting panels 12 are formed by being combined in the tiled arrangement is, for example, formed in a rectangular shape. The first light emitting panels 11 are disposed in both ends of the light emitting surface in a lateral direction and the first light emitting panels 11 are disposed along the light emitting surface in a longitudinal direction. The second light emitting panels 12 are disposed between the first light emitting panels 11 of both ends in the lateral direction.

In the first light emitting panel 11, the transparent region 90 is directed to the outside in the lateral direction. The opaque region 80 in the first light emitting panel 11 is adjacent to the second light emitting panel 12 that is the opaque one-side emission panel. Then, the opaque region 80 illustrated in cross-hatching in FIG. 4B is formed by combining the opaque region 80 of the first light emitting panel 11 and the second light emitting panel 12.

In the entirety of the lighting apparatus 2, the transparent region 90 (the both-side emission region) is disposed in both ends of the light emitting surface in the lateral direction and the opaque region 80 (the one-side emission region) is spread between the transparent regions 90 of both ends thereof.

The apparatus body 40 is provided by being superimposed on the opaque region 80. The external size of the apparatus body 40 is sized to fit within the opaque region 80 and the apparatus body 40 is not superimposed on the transparent region 90. Otherwise, a part of the apparatus body 40 may protrude from the opaque region 80 into the side of the transparent region 90. In any event, at least a part of the transparent region 90 is not covered by the apparatus body 40 and it is possible to take out the light on the side of the back surface (the side of the ceiling) from the transparent region 90.

In the transparent region 90, similar to the first embodiment, a part of the light directed from the light emitting layer 32 to the side of the second electrode 22 is taken out to the side of the ceiling surface by being transmitted through the second metal film section 22b. At this time, since the apparatus body 40 does not cover the transparent region 90, the light directed to the side of the ceiling surface is not blocked by the apparatus body 40.

Therefore, according to the second embodiment, it is possible to take out the light to the side of the back surface and to illuminate the installation surface such as the ceiling surface without providing a separate light source on the side of the back surface of the lighting apparatus 2.

Further, in the opaque region 80, the light directed to the side of the back surface (the side of the ceiling) is taken out from the main light take-out surface of the side of the first electrode by being reflected in the second electrode.

Therefore, according to the second embodiment, it is also possible to illuminate the side of the installation surface such as the ceiling surface while suppressing reduction of the light amount radiating to the side of the main light take-out surface.

Further, the transparent region 90 has transparency to infrared radiation. Thus, it is possible to remotely control the lighting apparatus 2 by providing the receiving section of the transmitting signal of the remote controller that operates the lighting apparatus 2 on the back side of the transparent region 90. Otherwise, it is also possible to provide the receiving section of the human sensor, the brightness sensor or the like on the back side of the transparent region 90.

It is possible to reduce the planar size of the entirety of the lighting apparatus 2 by providing the receiving section described above in the position superimposed on the light emitting panel without providing the receiving section on the outside of the end portion of the light emitting panel.

### Third Embodiment

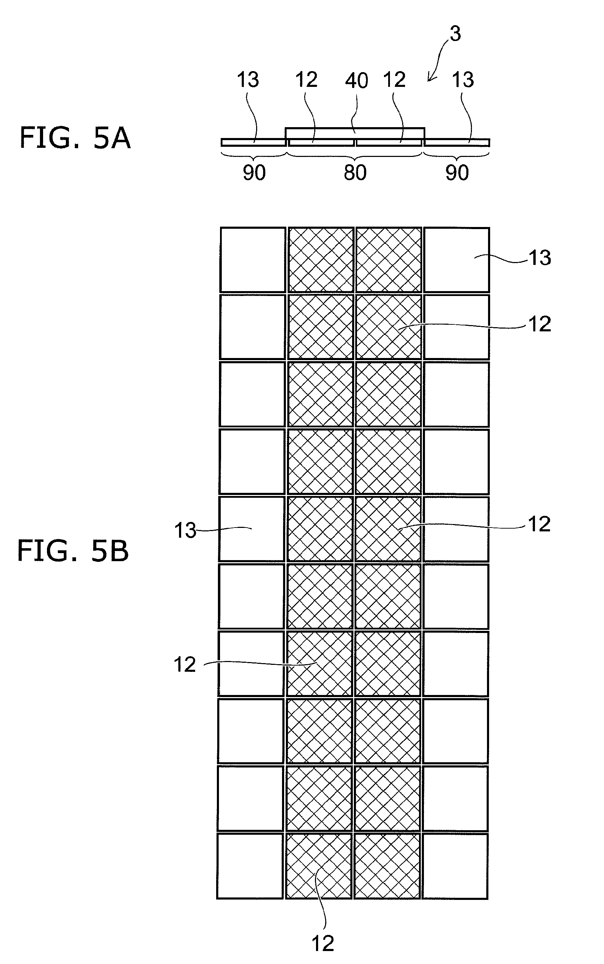

FIG. 5A is a schematic view of a lighting apparatus 3 of a third embodiment.
FIG. 5B is a schematic plan view of the lighting apparatus 3 of the third embodiment.

The lighting apparatus 3 of the third embodiment has a plurality of transparent light emitting panels 13 and a plurality of opaque light emitting panels 12 which are arranged in the tiled arrangement. The plurality of transparent light emitting panels 13 and the plurality of opaque light emitting panels 12 are held on the apparatus body 40.

For example, the ceiling surface is positioned on the upper side in FIG. 5A. The lighting apparatus 3 is attached to the ceiling surface through the apparatus body 40 in a state where the transparent light emitting panel 13 and the opaque light emitting panel 12 are directed downward on the opposite side to the ceiling surface.

The transparent light emitting panel 13 and the opaque light emitting panel 12 are the light emitting panel having the OLED structure using organic electroluminescence. That is, the transparent light emitting panel 13 and the opaque light emitting panel 12 have the structure in which the organic layer including the light emitting layer is sandwiched between the first electrode and the second electrode.

In the transparent light emitting panel 13 and the opaque light emitting panel 12, similar to the light emitting panel 11 of the first embodiment, the first electrode is provided on the side of the transparent substrate and is transparent.

In the transparent light emitting panel 13, the second electrode is the transparent electrode. Otherwise, similar to the second metal film section 22b of the light emitting panel 11 of the first embodiment, the second electrode is the thin metal film having light transparency. That is, the transparent light emitting panel 13 is the both-side emission panel in which the sides of both surfaces of the organic layer are transparent.

In the opaque light emitting panel 12, the second electrode is the metal film. The second electrode thereof has a sufficient thickness throughout the entire region on the upper surface of the organic layer and is opaque. That is, the opaque light emitting panel 12 is the opaque light emitting panel of the one-side emission type where the side of the back surface on which the second electrode is provided in the organic layer is opaque.

The side of the first electrode (the side of the substrate) with the transparent light emitting panel 13 and the opaque light emitting panel 12 is the main light take-out surface, and the apparatus body 40 is provided on the side of the back surface (the side of the second electrode) on the other side thereof.

As illustrated in FIG. 5B, the light emitting surface on which the plurality of transparent light emitting panels 13 and the plurality of opaque light emitting panels 12 are formed by being combined in the tiled arrangement is, for example, formed in the rectangular shape. The transparent light emitting panels 13 are disposed in both ends of the light emitting surface in the lateral direction and the transparent light emitting panels 13 are disposed along the light emitting surface in the longitudinal direction. The opaque light emitting panels 12 are disposed between the transparent light emitting panels 13 of both ends in the lateral direction.

The region in which the opaque light emitting panels 12 are arranged is the opaque region 80 illustrated in cross-hatching in FIG. 5B.

In the entirety of the lighting apparatus 3, the transparent light emitting panels 13 (the transparent region 90) are disposed in both ends of the light emitting surface in the lateral direction and the opaque region 80 (the one-side emission region) is spread between the transparent regions 90 of both ends thereof.

The apparatus body 40 is provided by being superimposed on the opaque region 80. The external size of the apparatus body 40 is sized to fit within the opaque region 80 and the apparatus body 40 is not superimposed on the transparent region 90. Otherwise, a part of the apparatus body 40 may protrude from the opaque region 80 into the side of the transparent region 90. In any event, at least a part of the transparent region 90 is not covered by the apparatus body 40 and it is possible to take out the light on the side of the back surface (on the side of the ceiling) from the transparent region 90.

In the transparent region 90, the light directed from the light emitting layer to the side of the second electrode is taken out to the side of the ceiling surface by being transmitted through the second electrode. At this time, since the apparatus body 40 does not cover the transparent region 90, the light directed to the side of the ceiling surface is not blocked by the apparatus body 40.

Therefore, according to the third embodiment, it is possible to take out the light to the side of the back surface and to illuminate the installation surface such as the ceiling surface without providing a separate light source on the side of the back surface of the lighting apparatus 3.

Further, in the opaque region 80, the light directed to the side of the back surface (the side of the ceiling) is taken out from the main light take-out surface of the side of the first electrode by being reflected in the second electrode.

Therefore, according to the third embodiment, it is also possible to illuminate the side of the installation surface such as the ceiling surface while suppressing reduction of the light amount radiating to the side of the main light take-out surface.

Further, the transparent region 90 has transparency to infrared radiation. Thus, it is possible to remotely control the lighting apparatus 3 by providing the receiving section of the transmitting signal of the remote controller that operates the lighting apparatus 3 on the back side of the transparent region 90. Otherwise, it is also possible to provide the receiving section of the human sensor, the brightness sensor or the like on the back side of the transparent region 90.

It is possible to reduce the planar size of the entirety of the lighting apparatus 3 by providing the receiving section described above in the position superimposed on the light emitting panel without providing the receiving section on the outside of the end portion of the light emitting panel.

### Fourth Embodiment

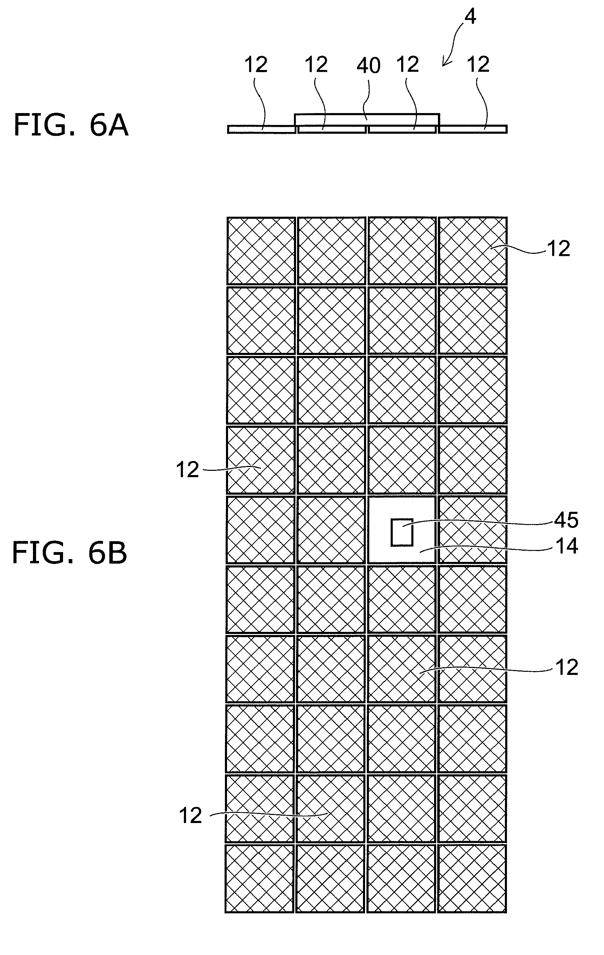

FIG. 6A is a schematic view of a lighting apparatus 4 of a fourth embodiment.
FIG. 6B is a schematic plan view of the lighting apparatus 4 of the fourth embodiment.

The lighting apparatus 4 of the fourth embodiment has the plurality of opaque light emitting panels 12 and at least one sheet of a transparent light emitting panel 14 which are arranged in the tiled arrangement. The opaque light emitting panels 12 and the transparent light emitting panel 14 are held on the apparatus body 40.

For example, the ceiling surface is positioned on the upper side in FIG. 6A. The lighting apparatus 4 is attached to the ceiling surface through the apparatus body 40 in a state where the opaque light emitting panels 12 and the transparent light emitting panel 14 are directed downward on the opposite side to the ceiling surface.

The opaque light emitting panels 12 and the transparent light emitting panel 14 are the light emitting panel having the OLED structure using the organic electroluminescence.

The opaque light emitting panels 12 have the same structure as the opaque light emitting panel of the embodiments described above. That is, in the opaque light emitting panel 12, the first electrode is provided on the side of the transparent substrate and is transparent. The second electrode is the metal film. The second electrode thereof has a sufficient thickness throughout the entire region on the upper surface of the organic layer and is opaque. That is, the opaque light emitting panel 12 is the opaque light emitting panel of the one-side emission type where the side of the back surface on which the second electrode is provided in the organic layer is opaque.

FIG. 7 is a schematic cross-sectional view of the transparent light emitting panel 14. As described below, the transparent light emitting panel 14 has transparency while performing the one-side emission.

The first electrode 21 is provided on the transparent substrate 20 such as the glass substrate or the resin substrate. The first electrode 21 is the transparent electrode such as ITO or IZO. The organic layer 30 is provided on the first electrode 21 thereof.

The organic layer 30 has the hole transport layer 31 provided on the first electrode 21, the light emitting layer 32 provided on the hole transport layer 31 and the electron transport layer 33 provided on the light emitting layer 32.

A second electrode 52 is provided on the upper surface (on the electron transport layer 33) of the organic layer 30. The second electrode 52 is an opaque metal electrode with respect to the light emitted from the light emitting layer 32. The second electrode 52 is linearly formed extending in a direction passing through a paper plane in FIG. 7. A plurality of linear second electrodes 52 are arranged on the organic layer 30 at intervals between each other.

The light emitting layer 32 emits the light in the region sandwiched between the first electrode 21 and the linear second electrodes 52. The light emitted between the first electrode 21 and the second electrodes 52 and directed to the side of the second electrodes 52 is reflected in the second electrodes 52 and then is taken out to the side of the substrate 20. Further, the light is not emitted in a region (a region between the adjacent second electrodes 52) in which the second electrodes 52 are not provided. Therefore, the light emitting panel illustrated in FIG. 7 is the one-side emission panel.

Further, a portion in which the second electrodes 52 are not provided on the side of the back surface (the upper surface in FIG. 7) in the organic layer 30 has light transparency and is transparent. Therefore, it is possible for the transmitting signal of the remote controller or the detection target light of the human sensor or the light sensor to be transmitted from the side of the substrate 20 to the side of the back surface.

That is, it is possible for various receiving sections disposed on the side of the back surface of the transparent light emitting panel 14 to receive external information through the transparent light emitting panel 14.

The side of the first electrode (the side of the substrate) with the opaque light emitting panel 12 and the transparent light emitting panel 14 is the light take-out surface and the apparatus body 40 is provided on the side of the back surface (the side of the second electrode) on the other side thereof.

As illustrated in FIG. 6B, for example, the rectangular-shaped light emitting surface is formed as a whole by combining the plurality of opaque light emitting panels 12 and one sheet of the transparent light emitting panel 14 in the tiled arrangement.

The region in which the plurality of opaque light emitting panels 12 are arranged is the opaque region illustrated in cross-hatching in FIG. 6B. In the opaque region, the light directed from the light emitting layer to the side of the back surface (the side of the ceiling) is reflected in the second electrode and then is taken out from the light take-out surface of the side of the first electrode.

For example, the region in which the transparent light emitting panel 14 is disposed is the transparent region having transparency to infrared radiation, visible light or the like. For example, a receiving section 45 of the transmitting signal of the remote controller that operates the lighting apparatus 4 is disposed on the back side of the transparent light emitting panel 14. It is possible to transmit the transmitting signal of the remote controller by transmitting through the transparent light emitting panel 14 from the lower side of the lighting apparatus 4 with respect to the receiving section 45 thereof.

Particularly, in the embodiment, since the receiving section 45 is disposed on the side of the back surface of the transparent light emitting panel 14 performing one-side emission and having transparency, the receiving section is very desirably disposed. That is, the transparent light emitting panel 14 is a panel which is transparent when not lighted and in which the light radiates on the side of the surface that is the light take-out side but the light does not radiate on the side of the back surface that is the side of the apparatus body 40 when lighted. Thus, the light of the transparent light emitting panel 14 does not radiate on the receiving section 45 and it is possible to suppress the reduction of reception sensitivity of the infrared radiation or the like of the receiving section 45 and degradation of the receiving section 45 by the light thereof. Further, it is possible to suppress the loss of the light amount.

Otherwise, as the receiving section 45, it is also possible to dispose the receiving section of the human sensor, the brightness sensor or the like on the back side of the transparent light emitting panel 14. It is possible for the receiving section 45 of the human sensor, the brightness sensor or the like to detect a human or brightness on the lower side of the lighting apparatus 4 through the transparent light emitting panel 14.

It is possible to reduce the planar size of the entirety of the lighting apparatus 4 by providing the various receiving sections 45 in a position superimposed on the light emitting panel without providing the receiving section 45 on the outside of an arrangement region of the light emitting panel. Particularly, the receiving section 45 is provided within the region of the apparatus body 40 and the transparent light emitting panel 14 is also preferably provided in such a way that at least a part of the transparent light emitting panel 14 is positioned within the region of the apparatus body 40 according to the position of the receiving section 45.

According to the fourth embodiment, almost all of the light emitting surface is the opaque region of the one-side emission and the light directed from the light emitting layer to the side of the back surface is reflected in the second electrode. That is, it is also possible for the light that is emitted to the side of the back surface to be derived to the lower side in the opaque region and the lighting is efficient. Furthermore, even if the receiving section 45 is disposed on the back side of the light emitting panel, it is possible for the receiving section 45 to receive (detect) the external information from the lower side of the panel by making a part thereof be the transparent region.

In the lighting apparatus of the embodiments described above in which a plurality of panels are combined, all of the one-side transmission panel, the both-side transmission panel and the non-transmission panel may be combined.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light emitting panel comprising:
an organic layer (30) including a light emitting layer (32);
a transparent first electrode (21) provided on one surface of the organic layer (30); and
a second electrode (22) provided on the other surface of the organic layer (30), and including an opaque first metal film section (22a), and a second metal film section (22b) having a film thickness thinner than a film thickness of the first metal film section (22a) and light transparency higher than light transparency of the first metal film section (22a).

2. The panel according to claim 1, wherein
the first metal film section (22a) has reflectivity to the light emitted from the light emitting layer (32) higher than reflectivity of the second metal film section (22b).

3. The panel according to claim 1 or 2, wherein
the first metal film section (22a) has transmission of 20% or more in a wavelength of 550 nm and the second metal film section (22b) has the transmission less than 20% in the wavelength of 550 nm.

4. The panel according to any one of claims 1 to 3, wherein
the first metal film section (22a) and the second metal film section (22b) are integrally provided with the same metal film.

5. A lighting apparatus comprising:
the light emitting panel (11) according to claim 1;
an opaque light emitting panel (12) in which one side surface of an organic layer including a light emitting layer has light transparency and the other side surface of the organic layer is opaque; and
an apparatus body (40) holding the light emitting panel (11) and the opaque light emitting panel (12).

6. The apparatus according to claim 5, wherein
an opaque region (80) is formed by combining a region in the light emitting panel (11) in which the first metal film section (22a) is provided and the opaque light emitting panel (12),
the apparatus body (40) is superimposed on the opaque region (80), and
at least a part of a transparent region where the second metal film section (22b) is provided in the light emitting panel (11) is not superimposed on the apparatus body (40).

7. The apparatus according to claim 5 or 6, further comprising:
a receiving section provided in a position superimposed on a transparent region (90) in which the second metal film section is provided, and receiving external information through the transparent region (90).

8. A lighting apparatus comprising:
a transparent light emitting panel (13, 14) in which both surfaces of an organic layer including a light emitting layer have light transparency;
an opaque light emitting panel (12) in which one side surface of an organic layer including a light emitting layer has light transparency and the other side surface of the organic layer is opaque; and
an apparatus body (40) holding the transparent light emitting panel (13, 14) and the opaque light emitting panel (12).

9. The apparatus according to claim 8, wherein
the apparatus body (40) is superimposed on the opaque light emitting panel (12), and
a region of at least a part of the transparent light emitting panel (13) is not superimposed on the apparatus body (40).

10. The apparatus according to claim 8 or 9, further comprising:
a receiving section (45) provided in a position superimposed on the transparent light emitting panel (13, 14) and receiving external information through the transparent light emitting panel (13, 14).

11. The apparatus according to claim 10, wherein
the transparent light emitting panel is an one-side emission panel (14) in which one surface emits the light, and
the receiving section (45) is disposed on the side of a non-light emitting surface of the one-side emission panel (14).
